# DEMANDE DE BREVET EUROPEEN

(11) **EP 3 208 906 A1**
(43) Date de publication de la demande: **23.08.2017**
(21) Numéro de dépôt: 17153393.8
(22) Date de dépôt: 26.01.2017
(51) Int. Cl.: H02H 7/122, H02P 29/024, H02P 3/22, H02M 7/5387, H03K 17/20

(54) **SYSTÈME DE COMMANDE D'UN ONDULEUR D'UN MOTEUR ÉLECTRIQUE, SYSTÈME DE MOTEUR COMPORTANT UN TEL SYSTÈME DE COMMANDE**

(30) Priorité: 17.02.2016 FR 1651264
(71) Demandeur: VALEO EQUIPEMENTS ELECTRIQUES MOTEUR, 94046 Créteil Cedex (FR)
(72) Inventeur: LECOCQ, Yann, 94370 Sucy en Brie (FR); LAHBIL, Hicham, 92120 MONTROUGE (FR)
(74) Mandataire: Novembre, Christophe Adelphe

(57) **Abrégé**

Un système de commande (122) d'un onduleur (116) comportant : un dispositif de commande (124) des interrupteurs (118₁, 118₂, 118₃, 120₁, 120₂, 120₃) ; pour chaque bras de l'onduleur (116), une connexion de côté haut (132₁, 132₂, 132₃) et une connexion de côté bas (134₁, 134₂, 134₃), le dispositif de commande (124) étant conçu pour appliquer des tensions de commande sur les connexions de côté haut (132₁, 132₂, 132₃) et sur les connexions de côté bas (134₁, 134₂, 134₃) pour sélectivement ouvrir et fermer les interrupteurs (118₁, 118₂, 118₃, 120₁, 120₂, 120₃) ; pour chaque connexion (134₁, 134₂, 134₃) d'un premier côté, un premier dispositif de sécurité (144) conçu pour, en cas d'absence de tension de commande sur la connexion de premier côté (134₁, 134₂, 134₃) considérée, appliquer sur la connexion de premier côté (134₁, 134₂, 134₃) considérée une première tension de sécurité destinée à fermer l'interrupteur de premier côté (120₁, 120₂, 120₃).

## Description

### DOMAINE TECHNIQUE

La présente invention concerne la sécurité des moteurs électrique à aimant permanent.

### ARRIÈRE-PLAN TECHNOLOGIQUE

Il est connu d'utiliser un système de commande d'un onduleur destiné à connecter des phases d'un moteur électrique à une première alimentation électrique conçue pour fournir une première tension continue par rapport à une première masse électrique, le moteur électrique comportant plusieurs phases, l'onduleur comportant, pour chaque phase, un bras comprenant un interrupteur de côté haut et un interrupteur de côté bas, l'interrupteur de côté haut étant destiné à être connecté entre une extrémité de la phase considérée et la première alimentation électrique, l'interrupteur de côté bas étant destiné à être connecté entre l'extrémité de la phase considérée et la première masse électrique, le système de commande comportant :
- un dispositif de commande des interrupteurs,
- pour chaque bras de l'onduleur, une connexion de côté haut et une connexion de côté bas connectées au dispositif de commande et destinées à être connectées respectivement à l'interrupteur de côté haut et à l'interrupteur de côté bas du bras considéré,
le dispositif de commande étant conçu pour appliquer des tensions de commande sur les connexions de côté haut et sur les connexions de côté bas pour sélectivement ouvrir et fermer les interrupteurs.

Or, pour un moteur électrique à aimant permanent, l'état sécurisé du moteur électrique est obtenu lorsque ses phases sont en court-circuit.

Le dispositif de commande comporte généralement plusieurs composants électriques alimentés par une alimentation électrique. Pour permettre de placer le moteur électrique dans son état sécurisé en cas de défaillance de l'un de ses composants, voire de l'alimentation électrique elle-même, il est connu de redonder ces composants et de les alimenter par une autre alimentation électrique, par exemple celle connectée à l'onduleur. Du fait de la redondance des composants électrique, cette solution est complexe et coûteuse.

L'invention a pour but de proposer un système de commande simple et néanmoins capable de placer les phases d'un moteur électrique en court-circuit.

### RÉSUMÉ DE L'INVENTION

À cet effet, il est proposé un système de commande d'un onduleur destiné à connecter des phases d'un moteur électrique à une première alimentation électrique conçue pour fournir une première tension continue par rapport à une première masse électrique, l'onduleur comportant, pour chaque phase, un bras comprenant un interrupteur de côté haut et un interrupteur de côté bas, l'interrupteur de côté haut étant destiné à être connecté entre une extrémité de la phase considérée et la première alimentation électrique, l'interrupteur de côté bas étant destiné à être connecté entre l'extrémité de la phase considérée et la première masse électrique, le système de commande comportant :
- un dispositif de commande des interrupteurs,
- pour chaque bras de l'onduleur, une connexion de côté haut et une connexion de côté bas connectées au dispositif de commande et destinés à être connectés respectivement à l'interrupteur de côté haut et à l'interrupteur de côté bas du bras considéré,
le dispositif de commande étant conçu pour appliquer des tensions de commande sur les connexions de côté haut et sur les connexions de côté bas pour sélectivement ouvrir et fermer les interrupteurs,
le système de commande étant caractérisé en ce qu'il comporte en outre, pour chaque connexion d'un premier côté parmi le côté haut et le côté bas, un premier dispositif de sécurité conçu pour, en cas d'absence de tension de commande sur la connexion de premier côté considérée, appliquer sur la connexion de premier côté considérée une première tension de sécurité destinée à fermer l'interrupteur de premier côté destiné à être connecté à la connexion de premier côté considérée.

Grâce à l'invention, et en particulier à la présence des premiers dispositifs de sécurité, la redondance des composants électriques du dispositif de commande peut être évitée.

De façon optionnelle, chaque connexion de premier côté comporte un conducteur principal de premier côté et un conducteur de référence de premier côté, le dispositif de commande étant conçu pour appliquer la tension de commande sur le conducteur principal de premier côté par rapport au conducteur de référence de premier côté, et chaque premier dispositif de sécurité comporte une première résistance présentant une première borne connectée au conducteur principal de premier côté et une deuxième borne destinée à être connectée à une deuxième alimentation conçue pour fournir une deuxième tension continue par rapport à une deuxième masse électrique.

De façon optionnelle également, au moins un premier dispositif de sécurité comporte une deuxième résistance présentant une première borne connectée au conducteur principal de premier côté et une deuxième borne connectée au conducteur de référence de premier côté.

De façon optionnelle également, au moins un premier dispositif de sécurité comporte une diode Zener présentant une cathode connectée au conducteur principal de premier côté et une anode connectée au conducteur de référence de premier côté.

De façon optionnelle également, le dispositif de commande comporte un premier pilote auquel chaque connexion de premier côté est connectée, le premier pilote est destiné à être connecté, pour son alimentation électrique, à une troisième alimentation électrique destinée à fournir une troisième tension continue par rapport à une troisième masse électrique et le premier pilote est conçu pour présenter, sur chaque connexion de premier côté, en cas d'absence d'alimentation électrique, une résistance de sortie supérieure à la première résistance du premier dispositif de sécurité associé, par exemple au moins 10 fois supérieure, de préférence au moins 100 fois supérieure. En particulier, la troisième masse électrique correspond à la première masse électrique.

De façon optionnelle également, le premier pilote comporte un point d'alimentation destiné à être connecté à la troisième alimentation électrique, le premier pilote présente, pour chaque conducteur principal de premier côté, une connexion entre le conducteur principal de premier côté et le point d'alimentation et le premier pilote comporte en outre, pour chaque connexion, une diode montée sur la connexion considérée pour empêcher une circulation de courant depuis le conducteur principal de premier côté vers le point d'alimentation.

De façon optionnelle également, le premier côté est le côté bas.

De façon optionnelle également, le système de commande comporte en outre, pour chacune des connexions d'un deuxième côté parmi le côté haut et le coté bas, un deuxième dispositif de sécurité conçu pour, en cas d'absence de tension de commande sur la connexion de deuxième côté considérée et sur la connexion de premier côté associée, appliquer à la connexion de deuxième côté considérée une deuxième tension de sécurité destinée à ouvrir l'interrupteur destiné à être connecté à la connexion de deuxième côté considérée.

De façon optionnelle également, chaque connexion de deuxième côté comporte un conducteur principal de deuxième côté et un conducteur de référence de deuxième côté, le dispositif de commande étant conçu pour appliquer la tension de commande sur le conducteur principal de deuxième côté par rapport au conducteur de référence de deuxième côté, et au moins un deuxième dispositif de sécurité comporte une résistance présentant une première borne connectée au conducteur principal de deuxième côté et une deuxième borne connectée au conducteur de référence de deuxième côté.

De façon optionnelle également, le deuxième côté est le côté haut.

Il est également proposé un système de moteur comportant :
- un moteur électrique comportant plusieurs phases,
- une première alimentation électrique conçue pour fournir une première tension continue par rapport à une première masse électrique,
- un onduleur destiné à connecter la première alimentation électrique au moteur électrique, l'onduleur comportant, pour chaque phase, un bras comprenant un interrupteur de côté haut et un interrupteur de côté bas, l'interrupteur de côté haut étant connecté entre une extrémité de la phase et la première alimentation électrique, l'interrupteur de côté bas étant connecté entre l'extrémité de la phase et la première masse électrique,
- un système de commande de l'onduleur selon l'invention.

De façon optionnelle, la deuxième alimentation est la première alimentation. En particulier, la deuxième tension continue correspond à la première tension continue et/ou la deuxième masse électrique correspond à la première masse électrique.

De façon optionnelle également, la troisième alimentation électrique est indépendante de la deuxième alimentation électrique.

### DESCRIPTION DES FIGURES

La figure 1 est un circuit électrique d'un système de moteur mettant en oeuvre l'invention.
La figure 2 est un circuit électrique d'un pilote de côté bas du système de moteur de la figure 1.
La figure 3 est un circuit électrique d'une variante de réalisation d'un premier dispositif de sécurité du système de moteur de la figure 1.

### DESCRIPTION DÉTAILLÉE

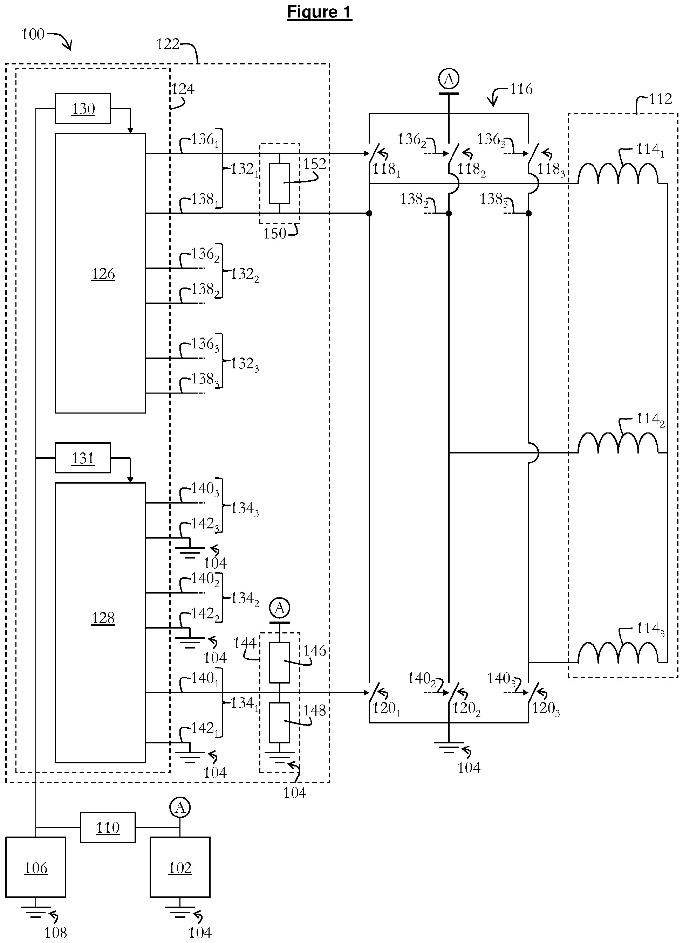

En référence à la figure 1, un système de moteur 100 selon l'invention va à présent être décrit. Le système de moteur 100 est par exemple destiné à être utilisé dans un véhicule automobile.

Le système de moteur 100 comporte une première alimentation électrique 102 conçue pour fournir une première tension continue A, par exemple 48V, par rapport à une première masse électrique 104. La première alimentation électrique 102 comporte par exemple une première batterie.

Le système de moteur 100 comporte en outre une deuxième alimentation électrique 106 conçue pour fournir une deuxième tension continue, de préférence inférieure à la première tension continue A, par exemple au moins deux fois inférieure, par exemple 12V, par rapport à une deuxième masse électrique 108. La deuxième alimentation électrique 106 comporte par exemple une deuxième batterie.

La première alimentation électrique 102 et la deuxième alimentation électrique 106 sont différentes et indépendantes l'une de l'autre, c'est-à-dire que l'arrêt de l'une n'entraîne pas l'arrêt de l'autre. Par exemple, la première batterie est différente de la deuxième batterie. En outre, la première alimentation électrique 102 et la deuxième alimentation électrique 106 sont isolées l'une de l'autre. Cela signifie en particulier que lorsqu'un composant électrique est connecté à la fois à la première alimentation électrique 102 et à la deuxième alimentation électrique 106, il comporte un isolateur électrique (barrière d'isolation) avec la première alimentation électrique 102 et/ou la deuxième alimentation électrique 106.

Le système de moteur 100 comporte en outre un convertisseur 110 connecté entre la première alimentation électrique 102 et la deuxième alimentation électrique 106. Le convertisseur 110 est conçu pour permettre la recharge d'une parmi la première alimentation électrique 102 et la deuxième alimentation électrique 106 par l'autre. Par exemple, le convertisseur 110 permet la recharge de la deuxième alimentation électrique 106 par la première alimentation électrique 102.

La première masse électrique 104 et la deuxième masse électrique 108 peuvent être reliées entre elles et ne former qu'une seule masse électrique, ou bien être séparées l'une de l'autre.

Le système de moteur 100 comporte en outre un moteur électrique 112 comportant plusieurs phases 114₁, 114₂, 114₃. Le moteur électrique 112 est par exemple un moteur électrique à aimant permanent. Dans l'exemple décrit, le moteur électrique 112 comporte trois phases 114₁, 114₂, 114₃. Le moteur électrique 112 est par exemple conçu pour entraîner des roues du véhicule automobile, par exemple en complément d'un moteur thermique du véhicule automobile lorsque le moteur thermique est embrayé, ou bien à la place du moteur thermique lorsque le moteur thermique est débrayé.

Le système de moteur 100 comporte en outre un onduleur 116 conçu pour connecter la première alimentation électrique 102 au moteur électrique 112 afin d'entraîner ce dernier.

L'onduleur 116 comporte, pour chaque phase 114₁, 114₂, 114₃ du moteur électrique 112, un bras de commutation comportant un interrupteur de côté haut 118₁, 118₂, 118₃ et un interrupteur de côté bas 120₁, 120₂, 120₃. L'interrupteur de côté haut 118₁, 118₂, 118₃ est connecté entre une extrémité de la phase 114₁, 114₂, 114₃ considérée et la première alimentation électrique 102. L'interrupteur de côté bas 120₁, 120₂, 120₃ est connecté entre l'extrémité de la phase 114₁, 114₂, 114₃ considérée et la première masse électrique 104.

Chaque interrupteur 118₁, 118₂, 118₃, 120₁, 120₂, 120₃ comporte dans l'exemple décrit un transistor à effet de champ à grille isolée (également désigné par l'acronyme MOSFET de anglais *«Metal Oxide Semiconductor Field Effect Transistor»*), ou bien un transistor bipolaire à grille isolée (également désigné par l'acronyme IGBT, de l'anglais *«Insulated Gate Bipolar Transistor»*). De préférence, les interrupteurs 118₁, 118₂, 118₃, 120₁, 120₂, 120₃ sont de type « normalement ouvert ».

Le système de moteur 100 comporte en outre un système de commande 122 de l'onduleur 116.

Le système de commande 122 comporte tout d'abord un dispositif de commande 124 des interrupteurs 118₁, 118₂, 118₃, 120₁, 120₂, 120₃, comportant lui-même un pilote de côté haut 126 et un pilote de côté bas 128.

Le système de commande 122 comporte en outre une alimentation électrique de côté haut 130 destinée à alimenter électriquement le pilote de côté haut 126 à partir de la deuxième alimentation électrique 106.

Le système de commande 122 comporte en outre une alimentation électrique de côté bas 131 destinée à alimenter électriquement le pilote de côté bas 128 à partir de la deuxième alimentation électrique 106.

Le système de commande 122 comporte en outre, pour chaque phase 114₁, 114₂, 114₃ du moteur électrique 112, une connexion de côté haut 132₁, 132₂, 132₃ et une connexion de côté bas 134₁, 134₂, 134₃.

Les connexions de côté haut 132₁, 132₂, 132₃ sont connectées, d'une part, au pilote de côté haut 126 et, d'autre part, respectivement aux interrupteurs de côté haut 118₁, 118₂, 118₃. Chaque connexion de côté haut 132₁, 132₂, 132₃ comporte un conducteur principal de côté haut 136₁, 136₂, 136₃ et un conducteur de référence de côté haut 138₁, 138₂, 138₃. Chaque conducteur principal de côté haut 136₁, 136₂, 136₃ est connecté à la grille du MOSFET ou de l'IGBT de l'interrupteur de côté haut 118₁, 118₂, 118₃ associé. Chaque conducteur de référence de côté haut 138₁, 138₂, 138₃ est connecté à la source du MOSFET ou de l'IGBT de l'interrupteur de côté haut 118₁, 118₂, 118₃ associé.

De même, les connexions de côté bas 134₁, 134₂, 134₃ sont connectées, d'une part, au pilote de côté bas 128 et, d'autre part, respectivement aux interrupteurs de côté bas 120₁, 120₂, 120₃. Chaque connexion de côté bas 134₁, 134₂, 134₃ comporte un conducteur principal de côté bas 140₁, 140₂, 140₃ et un conducteur de référence de côté bas 142₁, 142₂, 142₃. Chaque conducteur principal de côté bas 140₁, 140₂, 140₃ est connecté à la grille du MOSFET ou de l'IGBT de l'interrupteur de côté bas 120₁, 120₂, 120₃ associé. Chaque conducteur de référence de côté bas 142₁, 142₂, 142₃ est connecté à la source du MOSFET ou de l'IGBT de l'interrupteur de côté bas 120₁, 120₂, 120₃ associé. Dans l'exemple décrit, la source des transistors des interrupteurs de côté bas 120₁, 120₂, 120₃ est connectée à la première masse électrique 104, de sorte que les conducteurs de référence de côté bas 142₁, 142₂, 142₃ sont connectés à la première masse électrique 104.

Le pilote de côté haut 126 est conçu pour appliquer des tensions de commande sur les connexions de côté haut 132₁, 132₂, 132₃ (entre le conducteur principal de côté haut 136₁, 136₂, 136₃ et le conducteur de référence de côté haut 138₁, 138₂, 138₃) pour sélectivement ouvrir/fermer les interrupteurs de côté haut 118₁, 118₂, 118₃.

Le pilote de côté bas 128 est conçu pour appliquer des tensions de commande sur les connexions de côté bas 134₁, 134₂, 134₃ (entre le conducteur principal de côté bas 140₁, 140₂, 140₃ et le conducteur de référence de côté bas 142₁, 142₂, 142₃ - c'est-à-dire la première masse électrique 104) pour sélectivement ouvrir/fermer les interrupteurs de côté bas 120₁, 120₂, 120₃. Le pilote de côté bas 128 comprend une barrière d'isolation (non représentée).

Le pilote de côté haut 126 et le pilote de côté bas 128 sont conçus de sorte que chaque tension de commande qu'ils appliquent prend alternativement un niveau haut, par exemple compris entre 9 et 18V, de fermeture de l'interrupteur 118₁, 118₂, 118₃, 120₁, 120₂, 120₃, et un niveau bas, par exemple de 0V, d'ouverture de l'interrupteur 118₁, 118₂, 118₃, 120₁, 120₂, 120₃.

Par ailleurs, le pilote de côté bas 128 est conçu pour présenter sur chaque connexion de côté bas 134₁, 134₂, 134₃, en cas d'absence d'alimentation électrique, une résistance de sortie élevée, par exemple supérieure à un seuil compris entre 50 kΩ et 200 kΩ, par exemple 100 kΩ.

Le système de commande 122 comporte en outre, pour chacune des connexions de côté bas 134₁, 134₂, 134₃, un dispositif de sécurité de côté bas 144. Sur la figure 1, seul celui de la connexion de côté bas 134₁ est représenté, mais les autres connexions de côté bas 134₂, 134₃ en sont également munies. Chaque dispositif de sécurité de côté bas 144 est conçu pour, en cas d'absence de tension de commande sur la connexion de côté bas 134₁, 134₂, 134₃ considérée, appliquer à cette dernière une première tension de sécurité destinée à fermer l'interrupteur de côté bas 120₁, 120₂, 120₃ associé. La première tension de sécurité est par exemple comprise entre 9 et 18V. De préférence, les dispositifs de sécurité de côté bas 144 sont alimentés par une alimentation électrique différente et indépendante de l'alimentation électrique de côté bas 131 alimentant le pilote de côté bas 128. Dans l'exemple décrit, ils sont alimentés par la première alimentation électrique 102 qui alimente déjà les interrupteurs 118₁, 118₂, 118₃, 120₁, 120₂, 120₃. Ainsi, la présence des dispositifs de sécurité de côté bas 144 n'entraine pas de problème d'isolation.

Dans l'exemple décrit, chaque dispositif de sécurité de côté bas 144 comporte une première résistance 146 présentant une première borne connectée au conducteur principal de côté bas 140₁ et une deuxième borne connectée à la première alimentation 102. La première résistance 146 vaut par exemple entre 30 kΩ et 120 kΩ, par exemple 60 kΩ. Chaque dispositif de sécurité de côté bas 144 comporte en outre une deuxième résistance 148 présentant une première borne connectée au conducteur principal de côté bas 140₁ et une deuxième borne connectée au conducteur de référence de côté bas 142₁, c'est-à-dire à la première masse électrique 104. La deuxième résistance 148 vaut par exemple entre 10 kΩ et 40 kΩ, par exemple 20 kΩ.

Le pilote de côté bas 128 est conçu de manière à présenter, en l'absence d'alimentation, une résistance de sortie sur chaque connexion de côté bas 134₁, 134₂, 134₃ supérieure à la fois à la première résistance 146 et à la deuxième résistance 148 du dispositif de sécurité de côté bas 144 associé, par exemple au moins 10 fois supérieure, de préférence au moins 100 fois supérieure.

Comme la résistance de sortie du pilote de côté bas 128 est très élevée, chaque dispositif de sécurité de côté bas 144 se comporte comme un pont diviseur de tension et les valeurs de la première résistance 146 et de la deuxième résistance 148 sont choisies par rapport à la première tension continue A pour obtenir la première tension de sécurité. Par exemple, dans le cas où la première tension continue A vaut 48V, la première résistance 146 vaut par exemple 60 Ω et la deuxième résistance 148 vaut par exemple 20 Ω, ce qui permet d'obtenir une première tension de sécurité d'environ 10V.

Le système de commande 122 comporte en outre, pour chacune des connexions du côté haut 132₁, 132₂, 132₃, un dispositif de sécurité de côté haut 150. Sur la figure 1, seul celui de la connexion de côté haut 132₁ est représenté, mais les autres connexions de côté haut 132₂, 132₃ en sont également munies. Le dispositif de sécurité de côté haut 150 est conçu pour, en cas d'absence de tension de commande sur la connexion de côté haut 132₁, 132₂, 132₃ considérée ainsi que sur la connexion de côté bas 134₁, 134₂, 134₃ associée, appliquer à la connexion de côté haut 132₁, 132₂, 132₃ considérée une deuxième tension de sécurité destinée à ouvrir l'interrupteur de côté haut 118₁, 118₂, 118₃ associée. La deuxième tension de sécurité vaut par exemple 0V.

Dans l'exemple décrit, chaque dispositif de sécurité de côté haut 150 comporte une résistance 152 présentant une première borne connectée au conducteur principal de côté haut 136₁, 136₂, 136₃ et une deuxième borne connectée au conducteur de référence de côté haut 138₁, 138₂, 138₃. La résistance 152 vaut par exemple entre 10 kΩ et 40 kΩ, par exemple 20 kΩ.

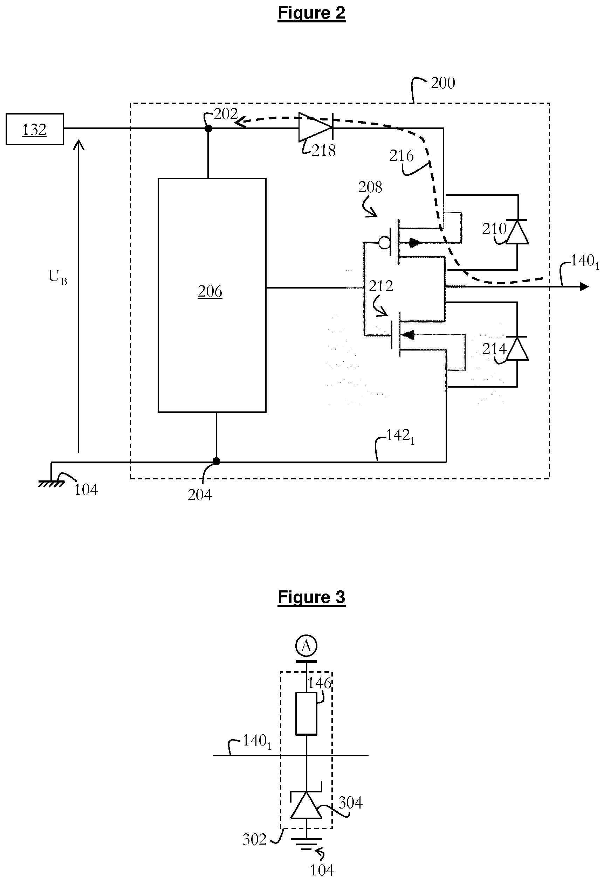

En référence à la figure 2, le pilote de côté bas 128 va à présent être décrit plus en détail.

Le pilote de côté bas 128 comporte, pour chaque connexion de côté bas 134₁, 134₂, 134₃, une cellule de pilotage 200. Sur la figure 2, seule la cellule de pilotage 200 de la connexion de côté bas 134₁ est représentée, mais des cellules de pilotage identiques sont également prévues pour les connexions de côté bas 134₂, 134₃.

Chaque cellule de pilotage 200 comporte un point d'alimentation 202 connectée à l'alimentation électrique de côté bas 131 et un point de masse 204 connecté à la première masse électrique 104.

Chaque cellule de pilotage 200 comporte en outre un circuit logique 206 connecté entre le point d'alimentation 202 et le point de masse 204 pour être alimenté par l'alimentation électrique de côté bas 131.

Chaque cellule de pilotage 200 comporte en outre un premier transistor 208 présentant une source connectée au point d'alimentation 202, une grille connectée au circuit logique 206 et un drain. Dans l'exemple décrit, le premier transistor 208 est un MOSFET de type p. Le premier transistor 208 présente en outre une diode 210 passante depuis le drain vers la source du premier transistor 208.

Chaque cellule de pilotage 200 comporte en outre un deuxième transistor 212 de type opposé au premier transistor 208, c'est-à-dire de type n dans l'exemple décrit. Le deuxième transistor 212 présente un drain connecté au drain du premier transistor 208, une source connectée au point de masse 204 et une grille connectée au circuit logique 206. Le deuxième transistor 212 présente en outre une diode 214 passante depuis la source vers le drain du deuxième transistor 212.

Le conducteur principal de côté bas 140₁ associé à la cellule de pilotage 200 est connecté aux drains du premier transistor 208 et du deuxième transistor 212. Comme les transistors 208, 212 sont de type opposé, le circuit logique peut les commander dans des états opposés avec la seule connexion sur leurs grilles.

Comme cela est visible sur la figure 2, chaque cellule de pilotage 200 présente une connexion 216 entre le conducteur principal de côté bas 140₁ et le point d'alimentation 202. Dans l'exemple de la figure 2, cette connexion 216 passe successivement par le drain et la source du premier transistor 208. En cas de défaut de la deuxième alimentation électrique 106 et donc de l'alimentation électrique de côté bas 131, il pourrait donc être possible que du courant entre dans le pilote de côté bas 128 par un conducteur principal de côté bas 140₁, 140₂, 140₃ pour atteindre le point d'alimentation 202. Il existerait donc un risque que le circuit logique 206 soit alimenté de manière intempestive par au moins l'un des conducteurs principaux de côté bas 140₁, 140₂, 140₃, en particulier du fait de la présence des dispositifs de sécurité de côté bas 144 qui sont alimentés par la première alimentation électrique 102. Pour éviter cette alimentation intempestive, chaque cellule de pilotage 200 comporte une diode 218 sur la connexion 216 agencée pour empêcher une circulation de courant depuis le conducteur principal de côté haut 140₁, 140₂, 140₃ vers le point d'alimentation 202. Ainsi, la diode 218 fournit la résistance de sortie élevée du pilote de côté bas 128 pour la connexion de côté bas 134₁.

Un exemple de fonctionnement du système de moteur 100 va à présent être décrit.

En fonctionnement normal, le pilote de côté haut 126 est alimenté par l'alimentation électrique de côté haut 130 et applique sur chacune des connexions de côté haut 132₁, 132₂, 132₃ une tension de commande prenant alternativement le niveau haut et le niveau bas décrit précédemment, pour respectivement ouvrir/fermer respectivement les interrupteurs de côté haut 118₁, 118₂, 118₃. De même, le pilote de côté bas 128 est alimenté par l'alimentation électrique de côté bas 131 et applique sur chacune des connexions de côté bas 134₁, 134₂, 134₃ une tension de commande prenant alternativement le niveau haut et le niveau bas décrit précédemment, pour respectivement ouvrir/fermer respectivement les interrupteurs de côté bas 120₁, 120₂, 120₃.

Les dispositifs de sécurité de côté bas 144 et les dispositifs de côté haut 150 n'ont alors pas d'effet.

En cas de défaut de la deuxième alimentation électrique 106, l'alimentation électrique de côté haut 130 et l'alimentation électrique de côté bas 131 cessent de fonctionner. Le pilote de côté haut 126 et le pilote de côté bas 128 ne sont alors plus alimentés et n'appliquent donc plus de tension de commande sur les connexions de côté haut 132₁, 132₂, 132₃ et les connexions de côté bas 134₁, 134₂, 134₃. Le potentiel des conducteurs principaux de côté haut 136₁, 136₂, 136₃ et des conducteurs principaux de côté bas 140₁, 140₂, 140₃ est alors flottant.

Chaque dispositif de sécurité de côté bas 144 impose alors la première tension de sécurité à la connexion de côté bas 134₁, 134₂, 134₃ associée, ce qui provoque la fermeture de tous les interrupteurs de côté bas 120₁, 120₂, 120₃. Les phases 114₁, 114₂, 114₃ du moteur électrique 112 sont alors en court-circuit, de sorte que le moteur électrique 112 est dans un état sécurisé. Dans l'exemple décrit, la première tension de sécurité est obtenue par division de la première tension continue A fournie par la première alimentation électrique 102, selon un rapport de division prédéterminé dépendant du choix de la première résistance 146 et de la deuxième résistance 148.

En outre, chaque dispositif de sécurité de côté haut 150 impose alors la deuxième tension de sécurité à la connexion de côté haut 132₁, 132₂, 132₃ associée. Dans l'exemple décrit, la deuxième tension de sécurité est obtenue par le fait que le conducteur principal de côté haut 136₁, 136₂, 136₃ et le conducteur de référence de côté haut 138₁, 138₂, 138₃ sont tous les deux connectés à la première masse électrique 104, de sorte que la deuxième tension de sécurité vaut 0V, ce qui provoque l'ouverture de tous les interrupteurs de côté haut 118₁, 118₂, 118₃.

Plus précisément, le conducteur de référence de côté haut 138₁, 138₂, 138₃ est connecté à la première masse électrique 104 par l'interrupteur de côté bas 120₁, 120₂, 120₃ correspondant, qui, grâce au dispositif de sécurité de côté bas 144, est fermé. Le conducteur principal de côté haut 136₁, 136₂, 136₃ est connecté au conducteur de référence de côté haut 138₁, 138₂, 138₃ par la résistance 152.

Il a été déterminé que les dispositifs de sécurité de côté bas 144 et les dispositifs de sécurité de côté haut 150 pouvaient se déclencher en moins de 100 µs, de sorte qu'il n'y a pas de problème de transitoire.

En référence à la figure 3, un dispositif de sécurité de côté bas 302 alternatif va à présent être décrit.

Ce dispositif de sécurité de côté bas 302 peut être utilisé à la place de chaque dispositif de sécurité de côté bas 144 de la figure 1.

Le dispositif de sécurité de côté bas 302 se distingue de celui de la figure 1, en ce que la deuxième résistance 148 est remplacée par une diode Zener 304 présentant une cathode connectée au conducteur principal de côté bas 140₁ et une anode connectée au conducteur de référence de côté bas 142₁ (la première masse électrique 104). La première alimentation électrique 102 est alors choisie de manière à fournir une première tension continue A suffisamment grande pour que la diode Zener 304 soit en configuration de claquage. Ainsi, la deuxième tension de sécurité correspond à la tension de claquage de la diode Zener 304. L'utilisation d'une diode Zener est intéressante car la deuxième tension de sécurité ne risque pas de changer en cas de changement intempestif de la première tension continue A fournie par la première alimentation électrique 102.

Les dispositifs de sécurité de côté bas 144, 302 agissent lorsque le système de moteur 100 est en cours de fonctionnement et qu'une absence de tension de commande intervient de manière non souhaitée, par exemple à cause d'une perte de l'alimentation électrique de côté bas 131, comme expliqué précédemment. En revanche, lorsque le système de moteur 102 est à l'arrêt, les première et deuxième alimentations 102, 106 sont déconnectées et les interrupteurs 118₁, 118₂, 118₃, 120₁, 120₂, 120₃, sont alors à l'état ouvert, puisqu'ils sont de type « normalement ouvert ».

La présente invention n'est pas limitée aux modes de réalisation décrits précédemment, mais est au contraire définie par les revendications qui suivent. Il sera en effet apparent à l'homme du métier que des modifications peuvent y être apportées.

Par exemple, l'invention pourrait s'appliquer à une machine présentant N phases, N étant supérieur ou égal à trois.

En outre, les dispositifs de sécurité 144 provoquant la fermeture des interrupteurs pourraient être placés sur les connexions de côté haut 132₁, 132₂, 132₃ plutôt que sur les connexions de côté bas 134₁, 134₂, 134₃.

En outre, les dispositifs de sécurité 144 pourraient être alimentés par une troisième alimentation, indépendante à la fois de la première alimentation électrique 102 et de la deuxième alimentation électrique 106.

Par ailleurs, les termes utilisés dans les revendications ne doivent pas être compris comme limités aux éléments des modes de réalisation décrits précédemment, mais doivent au contraire être compris comme couvrant tous les éléments équivalents que l'homme du métier peut déduire à partir de ses connaissances générales.

## Revendications

1. Système de commande (122) d'un onduleur (116) destiné à connecter des phases (114₁, 114₂, 114₃) d'un moteur électrique (112) à une première alimentation électrique (102) conçue pour fournir à l'onduleur (116) une première tension continue (A) par rapport à une première masse électrique (104), l'onduleur (116) comportant, pour chaque phase (114₁, 114₂, 114₃), un bras comprenant un interrupteur de côté haut (118₁, 118₂, 118₃) et un interrupteur de côté bas (120₁, 120₂, 120₃), l'interrupteur de côté haut (118₁, 118₂, 118₃) étant destiné à être connecté entre une extrémité de la phase (114₁, 114₂, 114₃) considérée et la première alimentation électrique (102), l'interrupteur de côté bas (120₁, 120₂, 120₃) étant destiné à être connecté entre l'extrémité de la phase (114₁, 114₂, 114₃) considérée et la première masse électrique (104), le système de commande (122) comportant :
- un dispositif de commande (124) des interrupteurs (118₁, 118₂, 118₃, 120₁, 120₂, 120₃),
- pour chaque bras de l'onduleur (116), une connexion de côté haut (132₁, 132₂, 132₃) et une connexion de côté bas (134₁, 134₂, 134₃) connectées au dispositif de commande (124) et destinées à être connectées respectivement à l'interrupteur de côté haut (118₁, 118₂, 118₃) et à l'interrupteur de côté bas (120₁, 120₂, 120₃) du bras considéré,
le dispositif de commande (124) étant conçu pour appliquer des tensions de commande sur les connexions de côté haut (132₁, 132₂, 132₃) et sur les connexions de côté bas (134₁, 134₂, 134₃) pour sélectivement ouvrir et fermer les interrupteurs (118₁, 118₂, 118₃, 120₁, 120₂, 120₃),
le système de commande (122) étant **caractérisé en ce qu'**il comporte en outre, pour chaque connexion (134₁, 134₂, 134₃) d'un premier côté parmi le côté haut et le côté bas, un premier dispositif de sécurité (144 ; 302) conçu pour, en cas d'absence de tension de commande sur la connexion de premier côté (134₁, 134₂, 134₃) considérée, appliquer sur la connexion de premier côté (134₁, 134₂, 134₃) considérée une première tension de sécurité destinée à fermer l'interrupteur de premier côté (120₁, 120₂, 120₃) destiné à être connecté à la connexion de premier côté (134₁, 134₂, 134₃) considérée.

2. Système de commande (122) selon la revendication 1,
dans lequel chaque connexion de premier côté (134₁, 134₂, 134₃) comporte un conducteur principal de premier côté (140₁, 140₂, 140₃) et un conducteur de référence de premier côté (142₁, 142₂, 142₃), le dispositif de commande (124) étant conçu pour appliquer la tension de commande sur le conducteur principal de premier côté (140₁, 140₂, 140₃) par rapport au conducteur de référence de premier côté (142₁, 142₂, 142₃),
et dans lequel chaque premier dispositif de sécurité (144 ; 302) comporte une première résistance (146) présentant une première borne connectée au conducteur principal de premier côté (140₁) et une deuxième borne destinée à être connectée à une deuxième alimentation électrique (102) conçue pour fournir une deuxième tension continue par rapport à une deuxième masse électrique (104).

3. Système de commande (122) selon la revendication 2, dans lequel au moins un premier dispositif de sécurité (144) comporte une deuxième résistance (148) présentant une première borne connectée au conducteur principal de premier côté (140₁) et une deuxième borne connectée au conducteur de référence de premier côté (142₁).

4. Système de commande (122) selon la revendication 2 ou 3, dans lequel au moins un premier dispositif de sécurité (302) comporte une diode Zener (304) présentant une cathode connectée au conducteur principal de premier côté (140₁) et une anode connectée au conducteur de référence de premier côté (142₁).

5. Système de commande (122) selon l'une quelconque des revendications 2 à 4,
dans lequel le dispositif de commande (124) comporte un premier pilote (128) auquel chaque connexion de premier côté (134₁, 134₂, 134₃) est connectée,
dans lequel le premier pilote (128) est destiné à être connecté, pour son alimentation électrique, à une troisième alimentation électrique (131) destinée à fournir au premier pilote (128) une troisième tension continue (U_{B}) par rapport à une troisième masse électrique (104),
et dans lequel le premier pilote (128) est conçu pour présenter, sur chaque connexion de premier côté (134₁, 134₂, 134₃), en cas d'absence d'alimentation électrique, une résistance de sortie supérieure à la première résistance (146) du premier dispositif de sécurité (144 ; 302) associé, par exemple au moins 10 fois supérieure, de préférence au moins 100 fois supérieure.

6. Système de commande (122) selon la revendication 5,
dans lequel le premier pilote (128) comporte un point d'alimentation (202) destiné à être connecté à la troisième alimentation électrique (131),
dans lequel le premier pilote (128) présente, pour chaque conducteur principal de premier côté (140₁, 140₂, 140₃), une connexion (216) entre le conducteur principal de premier côté (140₁, 140₂, 140₃) considéré et le point d'alimentation (202),
et dans lequel le premier pilote (128) comporte en outre, pour chaque connexion (216) entre un conducteur principal de premier côté (140₁, 140₂, 140₃) et le point d'alimentation (202), une diode (218) montée sur la connexion (216) considérée pour empêcher une circulation de courant depuis le conducteur principal de premier côté (140₁, 140₂, 140₃) vers le point d'alimentation (202).

7. Système de commande (122) selon l'une quelconque des revendications 1 à 6, dans lequel le premier côté est le côté bas.

8. Système de commande (122) selon l'une quelconque des revendications 1 à 7, comportant en outre, pour chacune des connexions d'un deuxième côté (132₁, 132₂, 132₃) parmi le côté haut et le coté bas, un deuxième dispositif de sécurité (150) conçu pour, en cas d'absence de tension de commande sur la connexion de deuxième côté (132₁, 132₂, 132₃) considérée et sur la connexion de premier côté (134₁, 134₂, 134₃) associée, appliquer sur la connexion de deuxième côté (132₁, 132₂, 132₃) considérée une deuxième tension de sécurité destinée à ouvrir l'interrupteur de deuxième côté (118₁, 118₂, 118₃) destiné à être connecté à la connexion de deuxième côté (132₁, 132₂, 132₃) considérée.

9. Système de commande (122) selon la revendication 8,
dans lequel chaque connexion de deuxième côté (132₁, 132₂, 132₃) comporte un conducteur principal de deuxième côté (136₁, 136₂, 136₃) et un conducteur de référence de deuxième côté (138₁, 138₂, 138₃), le dispositif de commande (124) étant conçu pour appliquer la tension de commande sur le conducteur principal de deuxième côté (136₁, 136₂, 136₃) par rapport au conducteur de référence de deuxième côté (138₁, 138₂, 138₃), et dans lequel au moins un deuxième dispositif de sécurité (150) comporte une résistance (152) présentant une première borne connectée au conducteur principal de deuxième côté (136₁, 136₂, 136₃) et une deuxième borne connectée au conducteur de référence de deuxième côté (138₁, 138₂, 138₃).

10. Système de commande (122) selon les revendications 8 et 9, dans lequel le deuxième côté est le côté haut.

11. Système de moteur (100) comportant :
- un moteur électrique (112) comportant plusieurs phases (114₁, 114₂, 114₃),
- une première alimentation électrique (102) conçue pour fournir une première tension continue (A) par rapport à une première masse électrique (104),
- un onduleur (116) destiné à connecter la première alimentation électrique (102) au moteur électrique (112), l'onduleur (116) comportant, pour chaque phase (114₁, 114₂, 114₃), un bras comprenant un interrupteur de côté haut (118₁, 118₂, 118₃) et un interrupteur de côté bas (120₁, 120₂, 120₃), l'interrupteur de côté haut (118₁, 118₂, 118₃) étant connecté entre une extrémité de la phase (114₁, 114₂, 114₃) et la première alimentation électrique (102), l'interrupteur de côté bas (120₁, 120₂, 120₃) étant connecté entre l'extrémité de la phase (114₁, 114₂, 114₃) et la première masse électrique (104),
- un système de commande (122) de l'onduleur (116) selon l'une quelconque des revendications 1 à 10.

12. Système de moteur (100) selon la revendication 11,
dans lequel le système de commande (122) est selon la revendication 2,
dans lequel la deuxième alimentation électrique (102) est la première alimentation électrique (102).

13. Système de moteur (100) selon la revendication 11 ou 12,
dans lequel le système de commande (122) est selon la revendication 5,
et dans lequel la troisième alimentation électrique (131) est indépendante de la deuxième alimentation électrique (102).
